# EUROPÄISCHE PATENTANMELDUNG

(11) **EP 1 221 496 A1**
(43) Veröffentlichungstag der Anmeldung: **10.07.2002**
(21) Anmeldenummer: 01130783.2
(22) Anmeldetag: 22.12.2001
(51) Int. Cl.: C23C 14/56, C23C 14/02

(54) **Verfahren und Vorrichtung zur Herstellung optischer Elemente**

(30) Priorität: 05.01.2001 DE 10101014
(71) Anmelder: CARL ZEISS SEMICONDUCTOR MANUFACTURING TECHNOLOGIES AG, 73446 Oberkochen (DE)
(72) Erfinder: Dreistein, Jörg, 73434 Aalen (DE); Weigl, Bernhard, 89555 Steinheim (DE)
(74) Vertreter: Patentanwälte Ruff, Wilhelm, Beier, Dauster & Partner

(57) **Zusammenfassung**

Bei einem Verfahren zur Beschichtung optischer Elemente für mit Ultraviolettlicht arbeitende optische Systeme wird die Beschichtung in einer von der evakuierbaren Arbeitskammer (6) einer Beschichtungseinrichtung (2) durchgeführt. Es wird mindestens eine Schleuseneinrichtung (3) bereitgestellt, die eine evakuierbare und wahlweise von der Arbeitskammer abtrennbare oder mit der Arbeitskammer zur Durchführung optischer Elemente verbindbare Schleusenkammer (12) aufweist. Nach Unterbringung von optischen Elementen in der Schleusenkammer können in dieser verschiedene Behandlungsschritte an den zu bedampfenden oder bedampften Elementen durchgeführt werden. Die Behandlung kann insbesondere eine Reinigung mittels Ultraviolettlicht, eine kontrollierte Aufheizung oder Abkühlung und/oder eine Messung mindestens einer optischen Eigenschaft optischer Elemente umfassen. Die Nutzung von Schleusenkammern zur Vor- oder Nachbehandlung optischer Elemente unmittelbar vor oder nach einer Beschichtung erlaubt eine bessere Kontrolle des Beschichtungsprozesses und eine Fertigung beschichteter Elemente höchster Qualität bei minimalen Gesamtprozeßzeiten.

## Beschreibung

Die Erfindung betrifft ein Verfahren zum Beschichten optischer Elemente, insbesondere optischer Elemente für mit Ultraviolettlicht arbeitende optische Systeme, in einer Arbeitskammer einer Beschichtungseinrichtung sowie Einrichtungen zur Durchführung des Verfahrens.

In vielen Bereichen steigt der Bedarf nach leistungsfähigen optischen Elementen wie Linsen, Spiegeln, Prismen oder dergleichen, deren optische Eigenschaften, wie Transmissionsgrad, Reflexionsgrad, Absorptionsgrad und sonstige Eigenschaften (z.B. Laserbeständigkeit) im Hinblick auf die Verwendung mit Ultraviolettlicht optimiert sind. Licht aus diesem Wellenlängenbereich wird beispielsweise bei Mikrolithographiesystemen zur Herstellung von hochintegrierten Halbleiterbauelementen mit Hilfe von Wafer-Steppern oder Wafer-Scannern verwendet. Dabei beleuchtet eine Lichtquelle über eine Beleuchtungsoptik eine strukturierte Maske (Retikel), deren Bild mit Hilfe einer Projektionsoptik auf das zu strukturierende Element, beispielsweise einen mit Photoresist beschichteten Halbleiterwafer, abgebildet wird. Da bekanntlich die Feinheit der bei diesem Prozeß erzielbaren Strukturen zunimmt, je kürzer die Wellenlänge des verwendeten Lichts ist, wurden in den letzten Jahren neben den aus Quecksilberdampflampen erhältlichen Wellenlängen (z.B. g-Linie bei 436 nm und i-Linie bei 368 nm Wellenlänge) zunehmend Wellenlängen aus dem tiefen Ultraviolettbereich eingesetzt. Lichtquellen hierfür sind KrF-Excimerlaser mit 248 nm Wellenlänge, ArF-Excimerlaser mit 193 nm Wellenlänge und F₂-Laser mit 157 nm Wellenlänge. Die Nutzung noch kürzerer Wellenlängen bis in den Bereich weiche Röntgenstrahlung wird angestrebt.

Zur Erzielung einer gewünschten Funktionalität einer optischen Komponente ist es häufig vorteilhaft oder zwingend, eine oder mehrere Oberflächen mit einer optisch wirksamen, ein- oder mehrlagigen dünnen Beschichtung zu beschichten. Typische Schichtdicken einzelner Lagen einer Beschichtung liegen häufig in der Größenordnung von Bruchteilen der verwendeten Lichtwellenlänge. Entsprechend haben Mehrlagenbeschichtungen mit mehreren Einzelschichten nicht selten Gesamtschichtdicken von weniger als 500 nm oder 300 nm.

Die Herstellung dünner Beschichtungen stellt erhöhte Anforderungen an die Qualität der Beschichtungsprozeßführung, um insbesondere Verunreinigungen der zu beschichtenden Oberflächen und der Schichten zu vermeiden. Schon kleinste Verunreinigungen können eine Beschichtung und damit die beschichtete Komponente für den vorgesehenen Verwendungszweck unbrauchbar machen, so daß eine Aussonderung des Elementes oder eine zeit- und kostenaufwendige Wiederaufarbeitung notwendig wird. Beschichtungen müssen daher überwiegend im Hochvakuum oder Ultrahochvakuum durchgeführt werden. Die hierfür erforderlichen Anlagen sind teuer und können aufgrund langer Pumpzeiten bis zur Erreichung des Arbeitsdruckes den Gesamtprozeß verlangsamen.

Zur Verminderung von Verunreinigungen der zu beschichtenden Oberflächen optischer Elemente nach deren Endbearbeitung, beispielsweise durch Polieren, ist es bekannt, eventuell vorhandene Bearbeitungsrückstände in einem Ultraschallbad naßchemisch in einer geeigneten wässrigen Lösung zu reinigen und die so gereinigten Elemente nach einem letzten Bad in Reinstwasser zu trocknen und anschließend möglichst zeitnah in die Arbeitskammer der vorgesehenen Beschichtungsanlage einzubauen. Es ist auch bekannt, die eingebauten Elemente vor der Beschichtung in der bereits evakuierten Arbeitskammer der Beschichtungsanlage mit Hilfe einer Glimmentladung zu reinigen.

Vor und nach Abschluß der Beschichtung ist es üblich, die optischen Eigenschaften der beschichteten Elemente z.B. spektroskopisch zu vermessen, um eine Qualifizierung der Komponenten für nachfolgende Verwendungen zu ermöglichen und um Rückschlüsse auf den Verlauf und mögliche Verbesserungen beim Beschichtungsprozeß zu ermöglichen. Überlicherweise erfolgt die Nachreinigung ebenfalls naßchemisch.

Es hat sich gezeigt, daß mit dem beschriebenen Vorgehen auch bei sorgfältigster Durchführung jedes einzelnen Teilschrittes des Verfahrens (Vorbehandlung, Beschichtung, Nachbehandlung) die hohen Anforderungen an die Qualität optischer Komponenten für Ultraviolettlichtsysteme nicht immer oder nur mit höchstem Aufwand einzuhalten sind. Dies führt zu erhöhten Ausschußraten und damit zur Verteuerung der gebrauchsfähigen optischen Elemente. Der Gesamtprozeß ist außerdem sehr zeitaufwändig.

Demgemäß liegt der Erfindung die Aufgabe zugrunde, ein Verfahren und geeignete Einrichtungen vorzuschlagen, die im Zusammenhang mit der Beschichtung optischer Komponenten, insbesondere für Verwendung mit Ultraviolettlicht, eine Beschichtung auf eine optimal vorbereitete Oberfläche und/oder eine bessere Kontrollierbarkeit des Beschichtungsprozesses fördern, um dadurch die Ausschußrate und die Kosten für verwendbare, optische Elemente zu senken. Insbesondere soll auch eine Verkürzung des die Beschichtung umfassenden Gesamtprozesses erreicht werden.

Zur Lösung dieser Aufgabe schlägt die Erfindung ein Verfahren mit den Merkmalen von Anspruch 1, eine Schleuseneinrichtung mit den Merkmalen von Anspruch 9, sowie eine mit einer derartigen Schleuseneinrichtung ausgestattete Beschichtungsanlage mit den Merkmalen von Anspruch 17 vor. Vorteilhafte Weiterbildungen sind in den abhängigen Ansprüchen angegeben. Der Wortlaut sämtlicher Ansprüche wird durch Bezugnahme zum Inhalt der Beschreibung gemacht.

Bei dem erfindungsgemäßen Verfahren, das besonders zum Beschichten optischer Elemente der eingangs erwähnten Art vorgesehen ist, wird die Beschichtung in einer von der Umgebungsatmosphäre abschließbaren, evakuierbaren Arbeitskammer einer Beschichtungseinrichtung durchgeführt. Bei dieser kann es sich beispielsweise um eine Bedampfungsanlage zur physikalischen Dampfabscheidung (physical vapor deposition, PVD) handeln. Das Verfahren ist auch für andere Vakuumverfahren, beispielsweise die chemische Gasphasenabscheidung (chemical vapor deposition, CVD) oder abgeleitete Verfahren (z.B. LPCVD oder PICVD) oder Sputtern geeignet.

### Das Verfahren umfaßt folgende Schritte:

Bereitstellung mindestens einer Schleuseneinrichtung mit mindestens einer evakuierbaren und wahlweise von der Arbeitskammer der Beschichtungseinrichtung abtrennbaren oder mit der Arbeitskammer verbindbaren Schleusenkammer;
Positionierung bzw. Anordnung mindestens eines optischen Elements in der Schleusenkammer;
Behandlung des optischen Elements innerhalb der Schleusenkammer;
Angleichung der Atmosphären von Arbeitskammer und Schleusenkammer;
Überführung des optischen Elements zwischen Schleusenkammer und Arbeitskammer unter Ausschluß der Umgebungsatmosphäre.

Hierbei kann die Reihenfolge der Verfahrensschritte in Abhängigkeit vom Verfahrensfortschritt variieren und es können einzelne Verfahrensschritte in einem Gesamtprozeß mehrfach auftreten. Beispielsweise kann vor der Bestückung der Arbeitskammer in der Schleusenkammer eine Vorbehandlung der Elemente durchgeführt werden, bevor diese unter Ausschluß der Umgebungsatmosphäre von der Schleusenkammer in die Arbeitskammer überführt werden. In diesem Fall kann die Schleuseneinrichtung auch als Bestückungs- oder Einlaßschleuse bezeichnet werden. Nach Abschluß der Beschichtung können die optischen Elemente aus der Arbeitskammer unter Ausschluß der Umgebungsatmosphäre in die Schleusenkammer überführt werden, in der gegebenenfalls eine Nachbehandlung der optischen Elemente stattfinden kann. In diesem Fall kann die Schleuseneinrichtung als Außlaß- oder Entlassungsschleuse bezeichnet werden. Es kann eine einzelne Schleuseneinrichtung sowohl als Bestückungs-, als auch als Entlassungsschleuse dienen. Es ist aber auch möglich, beispielsweise bei einer Inline-Anordnung, getrennte Einlaß- und Auslaßschleusen vorzusehen.

Es können eine oder mehrere Schleuseneinrichtungen fest mit der Beschichtungseinrichtung verbunden sein, wozu beispielsweise das Gehäuse einer Schleuseneinrichtung vakuumdicht mit dem Gehäuse einer Beschichtungsanlage im Bereich einer Gehäuseöffnung verschweißt sein kann. Es ist auch möglich, separate bzw. abnehmbare Schleuseneinrichtungen vorzusehen, die bei Bedarf an die Beschichtungseinrichtung vakuumdicht angekoppelt, bzw. angedockt und wieder von dieser abgenommen werden können. Entsprechend ist es beispielsweise auch möglich, die Behandlung des Substrats innerhalb der Schleusenkammer vorzunehmen, während die Schleuseneinrichtung noch nicht oder nicht mehr an die Beschichtungseinrichtung angekoppelt, bzw. angedockt ist. So ist es möglich, eine Beschichtungseinrichtung einen oder mehrere durch die Schleuseneinrichtungen gebildete "Satelliten" zuzuordnen, in denen Vorbehandlungs- oder Nachbehandlungsschritte der zu beschichtenden oder beschichteten Komponente durchgeführt werden können, während die Beschichtungseinrichtung selbst schon für eine neue Beschichtungsaufgabe vorbereitet oder genutzt wird. Hierdurch sind insbesondere bei der Serienfertigung erhebliche Zeiteinsparungen möglich.

Die Verwendung von Schleuseneinrichtungen beim Bestücken und/oder Entladen der Arbeitskammer der Beschichtungseinrichtung bringt im Hinblick auf die Sauberkeit oder Geschwindigkeit des Beschichtungsprozesses auch dadurch Vorteile, daß eine vollständige Belüftung der Arbeitskammer vermieden werden kann. Hierdurch können Verunreinigungen der Beschichtungskammer weitgehend vermieden werden. Weiterhin kann der Druck in der Beschichtungskammer nach Einführung oder Entnahme von Beschichtungsobjekten über eine Schleuseneinrichtung schneller wieder die für den Prozeß erforderlichen niedrigen Werte erreichen. Dadurch können die Reinigungsintervalle der aufgrund ihrer groβen Pumpleistung bevorzugten Kryopumpen deutlich erhöht werden, wodurch wartungsbedingte Maschinenstillstandzeiten minimiert werden können. Auch dies führt zur Produktivitätssteigerung und Kostensenkung.

Schleusen sind in vielen Anwendungsbereichen als Vorräume von gasdichten und/oder kontaminationsgefährdeten Räumen bekannt und dienen als Übergangsraum zwischen einem beispielsweise evakuierbarem oder unter einer bestimmten Atmosphäre gehaltenen Arbeitsraum und der Umgebung. Häufig enthalten sie auch Förder- oder Handlingseinrichtungen zum Transport der zu verarbeitenden Gegenstände zwischen Schleusenkammer und Arbeitsraum. Eine Schleuseneinrichtung zum Transport von Brillengläsern in die Arbeitskammer einer Beschichtungsaparatur ist aus der internationalen Patentanmeldung WO 9213114 bekannt. Die Funktion der Schleuse geht nicht über den Angleich der Atmosphären zwischen Arbeits- und Schleusenkammer und dem Transport der noch unbeschichteten Brillengläser in die Beschichtungskammer hinaus.

Demgegenüber sieht die Erfindung vor, daß innerhalb der Schleusenkammer eine Behandlung der optischen Elemente stattfindet, die über diese Funktionen von Transport und Atmosphärenausgleich und ggf. über eine reine Temperaturmessung hinausgeht. Eine "Behandlung" im Sinne dieser Anmeldung umfaßt insbesondere eine Einwirkung auf das Beschichtungsobjekt, bzw. eine Wechselwirkung mit dem Beschichtungsobjekt, die auf eine Zustandsänderung bzw. Eigenschaftsänderung des Beschichtungsobjekts und/oder auf eine Erfassung seiner Eigenschaften abzielt, insbesondere in Form einer Messung seiner optischen Eigenschaften.

Eine bevorzugte Weiterbildung sieht vor, daß die Behandlung eine Reinigung der in der Schleusenkammer befindlichen Objekte umfaßt, die insbesondere durch Bestrahlung mit Ultraviolettlicht geeigneter Wellenlänge und Intensität durchführbar ist. Die UV-Reinigung kann berührungslos durchgeführt werden, so daß die Gefahr von mechanischen Beschädigungen der Elemente vermieden wird. Die Reinigungswirkung kann dadurch unterstützt werden, daß die Schleusenkammer während der Reinigung evakuiert und/oder mit Gas gespült wird, so daß abgetragene Verunreinigungspartikel aus der Schleusenkammer abgefördert werden können. Hierdurch kann Rekontamination auf ein Minimum herabgesetzt werden.

Eine andere Variante der Ultraviolettreinigung zeichnet sich dadurch aus, daß vor und/oder während der Reinigung die Atmosphäre in der Schleusenkammer mit einem Prozeßgas, z.B. Sauerstoff geeigneten Partialdrucks, angereichert wird. In Verbindung mit der einfallenden UV-Strahlung kann hierdurch eine Ozonisierung und/oder Radikalisierung der Schleusenkammeratmosphäre erreicht werden. Die überraschende Verbesserung der Reinigungswirkung durch die Bildung von Ozon und/oder die Bildung freier Radikale bei dieser gasunterstützten UV-Reinigung kann möglicherweise dadurch erklärt werden, daß die aktivierten Moleküle bevorzugt mit Kohlenstoffverbindungen unter Bildung von Kohlenstoffoxiden, z.B. CO oder CO₂, reagieren, die aufgrund vermindeter Reaktionsfreudigkeit in geringerem Maße zur Rekontamination der gereinigten Oberfläche führen.

Eine Reinigung, insbesondere mittels Ultraviolettlicht, kann in verschiedenen Stadien des Gesamtprozesses vorteilhaft sein. Insbesondere kann vor der Beschichtung eine Reinigung der Oberflächen noch unbeschichteter Elemente durchgeführt werden. Diese Vorreinigung kann sich insbesondere vorteilhaft auf die Haftung zwischen Substrat und Beschichtung auswirken. Außerdem können Verunreinigungseinschlüsse zwischen Substrat-und Beschichtungsfilm weitgehend vermieden werden. Es ist auch möglich, daß bei einer Mehrlagenbeschichtung zwischen zwei Beschichtungsschritten eine Zwischenreinigung durchgeführt wird. Hierzu kann das bereits ein- oder mehrfach beschichtete Element aus der Arbeitskammer in die Schleusenkammer überführt, dort beispielsweise mit UV-Licht gereinigt und anschließend zur weiteren Beschichtung zurück in die Arbeitskammer gefördert werden. Bei Bedarf kann die Zwischenreinigung jedesmal nach Erzeugung einer einzigen Schicht einer Mehrlagenbeschichtung durchgeführt werden. Alternativ oder zusätzlich zur Reinigung können auch andere Behandlungsschritte, z.B. Messungen, zwischen einzelnen Beschichtungsschritten durchgeführt werden.

Besondere Vorteile bietet auch eine Nachreinigung des fertig beschichteten Elementes in der Schleusenkammer. Es hat sich in Versuchen gezeigt, daß eine Nachreinigung i.d.R. umso wirkungsvoller ist, je kürzer der Zeitraum zwischen Abschluß der Beschichtung und der Nachreinigung ist. Eine Nachreinigung ist besonders nützlich bei Beschichtungsprozessen, in denen die zu beschichteten Elemente zur Beschichtung unterschiedlich ausgerichteter Oberflächen gewendet werden müssen. In diesem Fall kann es vorkommen, daß eine bereits fertig beschichtete Oberfläche auf einer der Beschichtungsmaterialquelle abgewandten Seite angeordnet ist und dadurch den Hintergrund der Anlage "sieht". Hier kann es zu Ansammlungen von Ablagerungen kommen, was sich bei einem fertig beschichteten Element häufig als Absorption der früher beschichteten Oberflächen zeigt. Selbstverständlich kann auch eine Zwischenreinigung zur Beseitigung von auf diese Weise entstandenen Verunreinigungen dienen. Durch die Möglichkeit, eine gegebenenfalls gewünschte Oberflächenreinigung zu beschichtender oder beschichteter Substrate in einer von der Beschichtungskammer gesonderten und von dieser abschließbaren Schleusenkammer durchzuführen, kann auf eine in der Beschichtungskammer angeordnete Reinigungseinrichtung verzichtet werden. Dadurch kann bei unverändeter Anlagengröße und vorteilhaft verringerter Gesamtfläche der inneren Oberfläche der Beschichtungskammer mehr Raum für zu beschichtende Objekte bereitgestellt werden. Außerdem werden Kontaminationen des Arbeitskammerinnenraumes vermieden, wie sie bei herkömmlichen Verfahren mit Reinigung innerhalb der Beschichtungskammer zwangsläufig aufgetreten sind.

Zur Sicherstellung einer gut kontrollierten Prozeßführung mit reproduzierbaren Ergebnissen hoher Qualität ist es unerläßlich, die durch die Beschichtung erzielten Eigenschaften der Objekte mit geeigneter Meßtechnik zu erfassen, um die tatsächlichen Eigenschaften mit den angestrebten Eigenschaften vergleichen zu können. Diese meßtechnische Qualifizierung ist notwendig, damit nur innerhalb einer vorgegebenen Toleranzbreite liegende Produkte nachfolgenden Verarbeitungsschritten zugeführt werden. Die Meßergebnisse, beispielsweise hinsichtlich Absorptionsverhalten, Transmissionsverhalten, Reflexionsverhalten oder anderer Eigenschaften lassen außerdem wertvolle Rückschlüsse auf mögliche Schwächen im Beschichtungsprozeß zu. Diese Erkenntnisse sind Voraussetzung für eine systematische Verbesserung der Qualität von Beschichtungsprozessen. Erst eine Messung vor der Beschichtung macht die gemessenen Ergebnisse zuverlässig auswertbar.

Gemäß bevorzugter Weiterbildungen umfaßt die in der Schleusenkammer durchführbare Behandlung eine Messung mindestens einer Eigenschaft von in der Schleusenkammer befindlichen Objekten. Alternativ oder zusätzlich zu optischen Eigenschaften kann beispielsweise auch die Temparatur der Objekte bestimmt werden. Durch die Integration der Meßtechnik in eine Schleuseneinrichtung ist eine nahezu unmittelbare Erfolgskontrolle des Bedampfungsprozesses möglich, die es erlaubt, den Einfluß von Fehlern oder Schwächen des Beschichtungsprozesses zuverlässig von Schwächen oder Fehlern bei nachgeschalteten Prozeßschritten zu unterscheiden. Dies ist ein großer Vorteil gegenüber bekannten Verfahren, bei denen die Schichtenqualifizierung häufig geraume Zeit nach Abschluß der Verdampfung stattfindet, so daß bei Auftreten von Fehlern nicht klar ist, ob ein Artefakt des Bedampfungsprozesses oder ein Artefakt von nachfolgender Wiederverschmutzung gemessen wurde. Zudem erlaubt die Messung in der Schleusenkammer eine Messung unter kontrollierter Atmosphäre, beispielsweise in Vakuum oder einem geeigneten Inertgas, so daß negative Einflüsse der Umgebungsatmosphäre auf die Messung, z.B. durch Absorption des Meßlichts, vermeidbar sind.

Die innerhalb einer Schleusenkammer durchführbare Behandlung kann auch eine kontrollierte Temperaturführung der in der Schleusenkammer befindlichen Objekte umfassen, also beispielsweise eine Aufheizung mit kontrollierbarer Heizrate auf eine vorgegebene Temperatur, das Halten auf einer vorgegebenen Temperatur und/oder eine gegebenenfalls hinsichtlich der Akühlrate kontrollierte Abkühlung. Eine Aufheizung der Temperaturen deutlich über Raumtemperatur, beispielsweise auf mehr als 100 °C, kann die Wirkung der Ultraviolettreinigung unterstützen. Es hat sich beispielsweise gezeigt, daß für die Erzielung einer vorgegebenen Reinigungsleistung die Intensität des Ultraviolettlichts reduziert werden kann, wenn das zu reinigende Objekt aufgeheizt ist. Bei einer gasunterstützten Reinigung ist jedoch zu beachten, daß zweckmäßig das auf die geheizten Objekte einströmende Gas ebenfalls auf eine der Objekttemperatur vergleichbare Temperatur aufgeheizt ist, um durch Wärmespannung verursachte oberflächliche Rißbildung am Substrat zu vermeiden. Dieses Problem tritt besonders bei kristallinen Substratmaterialien, wie Calciumfluorid oder Bariumfluorid, auf, welche aufgrund ihrer günstigen Absorptionseigenschaften für Ultraviolettlicht für in diesem Wellenlängenbereich arbeitende Optiksysteme bevorzugt eingesetzt werden.

Die Heizung der Substrate kann beispielsweise über ein oder mehrere Strahlheizelemente erfolgen, die innerhalb der Schleusenkammer an geeigneter Stelle angeordnet sein können. Alternativ oder zusätzlich kann auch eine Heizung mittels Heißgas vorgesehen sein. Auch eine Kombination von Strahlungs- und Konvektionsheizung ist möglich, wozu beispielsweise die Schleusenkammer mit einem der Wärmekopplung zwischen Strahlheizelementen und Beschichtungsobjekt dienenden Gas gefüllt werden kann. Die Wärmezufuhr zu den Objekten und die Wärmeabfuhr von den Objekten kann bei Verwendung geeigneter Gasatmosphäre schneller durchgeführt werden als in Vakuum, was Zeitvorteile im Gesamtprozeß bringt. Außerdem ermöglicht eine gasunterstützte Heizung eine besonders gleichmäßige Aufheizung oder Abkühlung, was insbesondere bei wärmespannungsempfindlichen Materialien, wie fluoridischen Einkristallen, von Vorteil ist.

Wie eingangs erwähnt, bringt die Erfindung besondere Vorteile bei der Beschichtung von optischen Elementen, die für den Einsatz von Ultraviolettlicht vorgesehen sind. Die Erfindung ist jedoch nicht auf derartige Beschichtungsobjekte beschränkt, sondern kann bei Beschichtungsobjekten jeder Art vorteilhaft sein, insbesondere wenn eine zügige Prozeßführung bei gleichzeitig hoher und gut reproduzierbarer Beschichtungsqualität erwünscht ist. Insofern kann der Begriff "optisches Element" stellvertretend für Beschichtungsobjekte jeder geeigneten Art verstanden werden.

Die Erfindung betrifft auch optische Elemente, bei denen mindestens eine Oberfläche mit Hilfe des erfindungsgemäßen Verfahrens beschichtet wurde sowie komplexere Optiksysteme, die unter Verwendung erfindungsgemäß beschichteter Optikelemente aufgebaut sind.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte, sowie für sich schutzfähige Ausführungen darstellen können.

Ausführungsbeispiele der Erfindung sind in den Zeichnungen dargestellt und werden im Folgenden näher erläutert. Es zeigen
Fig.1 eine schematische Darstellung einer Bedampfungsanlage mit einer einzigen, als Bestückungs- und Entlassungsschleuse dienenden Schleuseneinrichtung gemäß einer Ausführungsform der Erfindung und
Fig.2 eine schematische Ansicht einer anderen Ausführungsform einer Bedampfungsanlage mit einer Bestückungsschleuse und einer davon gesonderten Entlassungsschleuse.

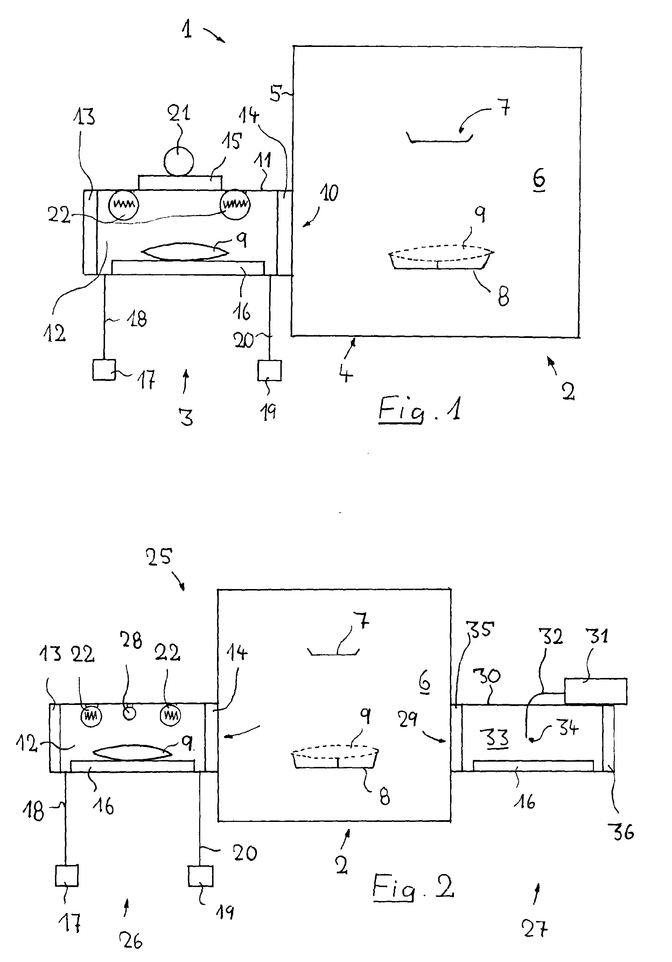

In Fig. 1 ist schematisch eine Beschichtungsanlage 1 gezeigt, die besonders für die Beschichtung von optischen Elementen für mit Ultraviolettlicht arbeitende optische Geräte optimiert ist. Bei den optischen Elementen kann es sich beispielsweise um Linsen, Prismen, Spiegel, Strahlteiler, Polarisierer, Filter oder andere Elemente handeln, die zum Aufbau von Beleuchtungs- oder Projektionsobjektiven oder anderen Funktionseinheiten von Anlagen zur UV-Mikrolithographie z.B. Lasern, vorgesehen sind.

Die Beschichtungsanlage 1 umfaßt als wesentliche Komponenten eine Bedampfungseinrichtung 2 und eine vakuumdicht an die Bedampfungseinrichtung angekoppelte Schleuseneinrichtung 3. Die Bedampfungseinrichtung 2 hat einen für Ultrahochvakuum ausgelegten Rezipienten 4 mit einem dickwandigen Edelstahlgehäuse 5, das eine Arbeitskammer 6 der Bedampfungseinrichtung umschließt. Zur Evakuierung der großvolumigen Arbeitskammer dient eine nicht gezeigte Kryopumpe, die mit ihrer Saugseite an die Arbeitskammer 6 angeschlossen ist. Im oberen Bereich der Arbeitskammer befindet sich eine elektrisch ansteuerbare Bedampfungsquelle 7, die auf eine darunterliegende Objektaufnahme 8 gerichtet ist.

In der Gehäusewand 5 ist eine vakuumdicht verschließbare Gehäusewandöffnung 10 zum Be- und Entladen der Arbeitskammer 6 vorgesehen. Im Bereich der Gehäusewandöffnung ist an der Außenseite des Rezipientengehäuses 5 eine abnehmbare Schleuseneinrichtung 3 mit einem kastenförmigen, vakuumdicht abschließbaren Edelstahlgehäuse 11 angekoppelt. Die nicht näher erläuterten Ankopplungsmittel, die beispielsweise nach Art eines Vakuumflansches ausgebildet sein können, erlauben eine starre, hochvakuumdichte, lösbare Verbindung zwischen den Gehäusen 5 und 11 von Bedampfungseinrichtung 2, bzw. Schleuseneinrichtung 3. Die vom Gehäuse 11 umschlossene Schleusenkammer 12 ist an ihren Schmalseiten durch Schleusenorgane 13, 14 vakuumdicht verschließbar und bei Öffnung mindestens eines der Schleusenorgane zugänglich. Die Schleuseneinrichtung ist mit ihren Schleusenorganen 13, 14 so dimensioniert, daß die größten, in der Bedampfungseinrichtung 2 bedampfbaren Objekte bei geöffneten Schleusenorganen durch die Schleuseneinrichtung ohne Gefahr der Beschädigung hindurchführbar sind. An mindestens einer Gehäuseseite, z.B. an der Oberseite des Gehäuses 11, ist in einer Gehäusewandöffnung ein Fenster 15 vakuumdicht eingelassen, das aus einem für Ultraviolettlicht transparentem Material, beispielsweise Quarzglas besteht.

Im Inneren des Schleusengehäuses 11 ist eine schematisch dargestellte, elektrisch antreibbare, mechanische Manipulationseinrichtung 16 eingebaut, die dazu dient, die durch die S chleuseneinrichtung zu transportierenden Gegenstände zu fördern und innerhalb der Schleuseneinrichtung an vorgebbaren Positionen in vorgebbaren Stellungen festzuhalten. Sie ist insbesondere dazu ausgebildet, bei geschlossenem ersten Schleusenorgan 13 und geöffnetem zweiten Schleusenorgan 14 zu bedampfende Objekte in die Arbeitskammer 6 zu überführen und/oder an eine dort angeordnete weitere Manipulationseinrichtung zu übergeben, bzw. bedampfte Objekte aus der Bedampfungskammer 6 in die Schleusenkammer 12 zu überführen. Die Manipulationseinrichtung kann z.B. mindestens ein Förderband und/oder mindestens ein drehbares und/oder verschiebbares Magazin oder dergleichen aufweisen. Im Beispiel trägt sie eine Linse 9 aus Calciumfluorid.

Die Atmosphäre innerhalb der Schleusenkammer 12 ist durch der Schleusenkammer zugeordnete Einrichtungen kontrollierbar. Diese umfassen eine Vakuumpumpe 17, von der eine Saugleitung 18 in die Schleusenkammer 12 führt und die so ausgelegt ist, daß das Innere der Schleusenkammer auf einen dem Arbeitsdruck der Arbeitskammer 6 im wesentlichen entsprechenden Restdruck evakuierbar ist. Außerdem ist mindestens eine Gasquelle 19 vorgesehen, von der eine Gasleitung 20 in die Schleusenkammer führt. Durch eine oder mehrere derartige Gasquellen kann die Schleusenkammer kontrolliert mit Gasen gewünschter Eigenschaften, beispielsweise mit Schutzgas, Stickstoff, Sauerstoff oder dergleichen, befüllt werden.

Eine Besonderheit der Erfindung besteht darin, daß die Schleuseneinrichtung über die genannten Mittel zur Förderung und Positionierung der zu schleusenden Objekte und der Einrichtungen zur Einstellung einer geeigneten Schleusenatmosphäre weitere Einrichtungen aufweist, die eine Behandlung der durchzuschleusenden Objekte innerhalb der Schleusenkammer ermöglichen. Auf diese Weise kann die Schleusenkammer 11 als weitere Arbeitskammer der gesamten Beschichtungsanlage genutzt werden, in der vor der Beschichtung die zu beschichtenden Objekte unter Ausschluß der Umgebungsatmosphäre für die Beschichtung optimal vorbereitet oder nach einer Beschichtung unter Umgebungsatmosphärenausschluß optimal nachbereitet werden können.

Besonders vorteilhaft ist eine Reinigungeinrichtung, die als wesentlichen Bestandteil mindestens eine Ultraviolettlichtquelle 21 umfaßt, die bei der Ausführungsform gemäß Fig. 1 außerhalb der Schleusenkammer 12 im Bereich des Fensters 15 derart angeordnet ist, daß die abgegebene UV-Strahlung mit hohem Wirkungsgrad auf ihr zugewandte Oberflächen der in der Schleusenkammer befindlichen Objekte 9 einwirken kann. Die beispielsweise als UV-Lichtröhre ausgebildete UV-Quelle 21 kann nach außen durch eine (nicht gezeigte) lichtundurchlässige Abdeckung abgeschirmt sein.

Es besteht außerdem die Möglichkeit, die Objekte im Inneren der Schleusenkammer kontrolliert auf vorgebbare Temperaturen aufzuheizen. Hierzu sind zwei Strahlungsheizer 22 vorgesehen, die im Inneren der Schleusenkammer an der Oberwand des Gehäuses 11 so angebracht sind, daß ihre Wärmestrahlung im wesentlichen auf die gleichen Oberflächen trifft, die auch der gegebenenfalls eingestrahlten UV-Strahlung der Lichtquelle 21 ausgesetzt sind.

Die Steuerung der Handhabungs- und Behandlungseinrichtungen sowie der Schleusenorgane kann wahlweise manuell oder über eine gemeinsame, nicht gezeigte, Steuereinheit computergestützt erfolgen.

Eine Beschichtungsanlage der hier beispielhaft beschriebenen Art ermöglicht eine Beschichtung optischer Komponenten oder anderer, zu beschichtender Objekte nach folgendem Verfahren.

Zum Beginn eines Beschichtungszyklus sei die Arbeitskammer 6 der Bedampfungsanlage auf Hochvakuum von z.B. weniger als 10⁻⁶ mbar evakuiert und zumindest das zweite Schleusenorgan 14 geschlossen. Sofern das erste Schleuseorgan 13 geschlossen ist, wird dieses geöffnet, um ein oder mehrere Objekte an die Manipulationseinrichtung 16 zu übergeben. Nach diesem Ladevorgang wird das erste Schleusenorgan geschlossen, wodurch die Schleusenkammer gasdicht abgeschlossen ist. Durch Einschalten der Ultraviolettlichtquelle 21 können nun der Lichtquelle zugewandte Oberflächen der Linse 9 von Verunreinigungen, insbesondere organischen Verunreinigungen gereinigt werden. Dieser Prozeß kann in einer der Umgebungsatmosphäre entsprechenden Atmosphäre durchgeführt werden. Es ist jedoch auch möglich, die Schleusenkammer mittels Pumpe 17 vor oder während der UV-Bestrahlung zu evakuieren, wobei einer Evakuierung während der Bestrahlung vorteilhaft sein kann, um Verunreinigungspartikel unmittelbar nach deren Ablösung vom Objekt abzusaugen und so eine Rekontimination der Objektoberfläche zu verhindern. Es ist auch möglich, einen Gasaustausch in der Schleusenkammer vorzunehmen, indem diese abgepumpt und zeitgleich oder anschließend ein geeignetes Gas aus der Gasquelle 18 in die Schleusenkammer eingelassen wird. In manchen Fällen hat sich eine Begasung mit Sauerstoff oder einem anderen sauerstoffhaltigen oder sauerstoffreien Prozeßgas als besonders vorteilhaft erwiesen, was möglicherweise darauf zurückzuführen ist, daß die unter UV-Lichtbestrahlung entstehenden Ozonmoleküle und/oder Radikale eine vorteilhafte Getterwirkung auf abgelöste Verunreinigungen, insbesondere solche mit Kohlenstoffatomen, ausüben und möglicherweise auch mechanisch auf die zu reinigende Oberfläche einwirken.

Die Reinigung kann durch eine Heizung des Objektes 9 unterstützt werden, indem vor oder während der UV-Bestrahlung die Heizstrahler 22 eingeschaltet werden. Während eine reine Strahlungsheizung bei gegen Wärmespannungen relativ unempfindlichen Objekten, beispielsweise solchen aus Siliziumglas, unproblematisch ist, können durch Wärmestrahlung verursachte Temperaturgradienten zwischen Objektoberfläche und Objektinnerem, insbesondere bei fluoridischen Einkristallen, wie Calciumfluorid, thermisch induzierte Risse verursachen. Das kann dadurch vermieden werden, daß die Aufheizung gasunterstützt erfolgt. Hierzu kann z.B. Heißgas in die Schleusenkammer eingeleitet werden oder die Schleusenkammer wird vor oder während der Einschaltung der Strahlheizkörper 22 mit einem als Wärmekopplungsmedium dienenden Gas gefüllt, um eine schonende und gleichmäßige Heizung des Objektes zu ermöglichen. Als Heißgas kann auch ein Prozeßgas verwendet werden, welches dann eine Doppelfunktion sowohl für die Aufheizung als auch für den Reinigungsprozeß hat.

Gegebenenfalls kann nach Abschluß der Reinigung der Reinigungserfolg spektroskopisch oder auf andere Weise gemessen werden, wie im Zusammenhang mit Fig. 2 noch näher erläutert wird. Nach Abschluß der Vorbehandlung erfolgt eine Angleichung der Atmosphären von Schleusenkammer 12 und Arbeitskammer 6, indem die Schleusenkammer auf Arbeitskammerdruck evakuiert wird. Die oben erwähnte Messung kann gegebenenfalls auch zu diesem Zeitpunkt, also in Vakuum, erfolgen. Dann wird das zweite Schleusenorgan 14 geöffnet, das Objekt in der Arbeitskammer 6 zur Bedampfung positioniert und das zweite Schleusenorgan wieder geschlossen, wodurch das Arbeitsintervall der Bedampfungseinrichtung eingeleitet wird.

In der Arbeitskammer 6 muß nach dieser Vorbehandlung während des Arbeitsintervalls keine weitere Vorbehandlung, insbesondere keine Reinigung des zu bedampfenden Objektes und/oder keine Aufheizung durchgeführt werden. Durch die Schleuseneinrichtung wird auch vermieden, daß die Arbeitskammer 6 bei Beschickung mit dem Bedampfungsobjekt belüftet werden muß, so daß die Arbeitskammer ständig evakuiert bleiben kann, was Verunreinigungen vermeidet und die im Gesamtprozeß erforderlichen Pumpzeiten drastisch reduziert. Außerdem ist es aufgrund der Vorheizung des Objekts in der Schleusenkammer nicht mehr erforderlich, in der Arbeitskammer entsprechende Heizeinrichtungen vorzusehen und Heizvorgänge durchzuführen. Dadurch werden starke Temperaturwechsel in der Prozeßkammer 6 vermieden, wodurch stabile Prozesse möglich sind.

Nach der Bedampfung, die in an sich bekannter Weise durchgeführt werden kann, wird das zweite Schleusenorgan 14 wieder geöffnet, das Objekt in die Schleusenkammer 12 überführt und das Schleusentor 14 wieder geschlossen. Auch in diesem Stadium ist bei geeigneter Ausstattung der Schleuseneinrichtung eine Qualifizierung des bedampften Objektes, beispielsweise mittels spektrometischer Messung von Reflexionsgrad, Transmissionsgrad und/oder Absorption oder dergleichen möglich. Der Schleusenraum 12 kann dann mit Schutzgas oder Luft geflutet werden bis auf einen Druck, der eine problemlose Öffnung des ersten Schleusenorgans 13 ermöglicht. Dann wird das Objekt entnommen und ein neues Objekt kann eingeschleust werden.

Die Beschichtungsanlage 25 in Fig. 2 ist für einen Inline-Betrieb ausgerüstet, bei der die Bestückung der Vorrichtung durch eine der Schleuseneinrichtung 3 entsprechende Bestückungsschleuseneinrichtung 26 und die Entnahme der Objekte durch eine gesonderte, gegenüberliegend angeordnete Entnahmeschleuseneinrichtung 27 erfolgen. Die Bestückungsschleuseneinrichtung 26 entspricht im Aufbau im wesentlichen der Schleuseneinrichtung 3 aus Fig. 1, weshalb für entsprechende Teile die gleichen Bezugszeichen verwendet werden. Ein Unterschied zur Ausführungsform nach Fig. 1 besteht darin, daß hier die UV-Lichtquelle 28 innerhalb der Schleusenkammer zwischen den Strahlheizkörpern 22 angeordnet ist, so daß das Fenster 15 entfallen kann. Die UV-Lichtquelle muß in diesem Fall zur Verwendung in Hochvakuumatmosphäre geeignet sein.

Die Entlassungsschleuseneinrichtung 27, die idealerweise im Bereich einer der Gehäuseöffnung 9 gegenüberliegenden Gehäuseöffnung 29 fest oder lösbar angeflanscht ist, ist als Meßschleuseneinrichtung konstruiert und erlaubt eine Messung von für die Qualifizierung der bedampften Objekte signifikaten Parametern wie Reflexionsgrad, Transmissionsgrad, Absorptionsgrad oder dergleichen unmittelbar nach der Bedampfung in Vakuum, ohne daß das bedampfte Objekt zwischenzeitlich der Umgebungsatmosphäre ausgesetzt werden muß. Hierzu ist auf der Oberseite des Gehäuses 30 als Meßeinrichtung ein Spektrometer 31 vorgesehen, von dem ein der Strahlführung dienender Lichtleiter 32 in das Innere der Schleusenkammer 33 führt. Das Austritts- bzw. Eintrittsende 34 des Lichtleiters ist so angeordnet, daß Licht auf eine zu qualifizierende Oberfläche des Objektes einstrahlbar und von dieser zurückfallendes oder transmittiertes Licht durch einen Sensor, z.B. über einen Lichtleiter auffangbar und zum Spektrometer rückführbar ist. Bei Bedarf kann in dieser Schleuse eine UV-Reinigung nach dem Beschichtungsvorgang vorgesehen sein (in Fig. 2 nicht dargestellt).

Die Beschickung der Arbeitskammer durch die Beladungsschleuse inklusive Reinigung und/oder Aufheizung des zu bedampfenden Objektes kann analog zu dem im Zusammenhang mit Fig. 1 beschriebenen Verfahren erfolgen. Im Unterschied zu diesem Verfahren kann jedoch hier nach Übergabe des Beschichtungsobjektes in die Arbeitskammer 6 und Schließen des zweiten Schleusenorgans 14 die Schleuseneinrichtung 26 schon für die Einschleusung eines oder mehrerer folgender Objekte vorbereitet werden, während in der Arbeitskammer die Bedampfung vorher eingebrachter Objekte durchführbar ist. Dadurch, daß durch Bereitstellung von mindestens zwei getrennten Schleuseneinrichtungen eine Einschleusung und/oder Ausschleusung zeitweise parallel zur eigentlichen Bedampfung durchgeführt werden kann, können erhebliche Zeitgewinne erzielt werden.

Ist die Bedampfung eines Objekts in der Arbeitskammer 6 abgeschlossen, so kann das Objekt nach Öffnen des dritten Schleusenorgans 35 in die vorher auf Anlagendruck evakuierte Schleusenkammer 33 überführt werden. Nach Schließen des dritten Schleusenorgans kann unmittelbar die Beladung der Arbeitskammer von Seiten der Einlaßschleuse 26 erfolgen. In dem als evakuierbaren Meßkammer dienenden Innenraum 33 der Entlassungsschleuseneinrichtung 27 kann nun das Ergebnis des Bedampfungsprozesses durch Einsatz des Spektrometers 31 und/oder anderer geeigneter Meßinstrumente überprüft werden. Die Ergebnisse dieser Messung erlauben zuverlässig Rückschlüsse auf die Qualität der Bedampfung, da bei auftretenden Fehlern ausgeschlossen werden kann, daß diese durch Einfluß der Umgebungsatmosphäre auf die fertige Beschichtung nach Abschluß der Bedampfung hervorgerufen sein könnten. Nach Abschluß der Messung kann der Schleuseninnenraum 33 mit Schutzgas oder Luft geflutet werden, um den Innenraum 33 auf einen dem Umgebungsdruck vergleichbaren Druck zu bringen, der zur Öffnung des vierten Schleusenorganes 36 erforderlich ist. Nach Öffnung dieses Schleusenorganes kann das Objekt entladen und die Schleuse wieder geschlossen werden. Anhand der beispielhaft erläuterten Aufbau- und Verfahrensvarianten wird ersichtlich, daß die durch die Erfindung mögliche Schleusentechnik an Beschichtungsanlagen für optische Teile oder dergleichen zu einer erheblichen Verringerung von Evakuierungszeiten und Pumpvorgängen in der Prozeßkammer 6 führen kann. Dadurch können bei einem Minimum an Pumpzeiten in einer normalerweise sehr teuren Beschichtungsanlage pro Zeiteinheit mehr Bedampfungsobjekte bearbeitet werden als bei vergleichbaren Anlagen ohne Schleusentechnik. Zudem können Temperaturwechsel innerhalb der Arbeitskammer auf ein Minimum reduziert werden, wodurch stabilere Bedampfungsprozesse realisierbar sind, die die Reproduzierbarkeit der hergestellten Beschichtungen verbessern. Nicht zuletzt erlaubt die prozeßnahe Qualifizierung durch die in die Schleuseneinrichtung integrierte Meßtechnik eine exaktere Kontrolle des Beschichtungsprozesses und ermöglicht dadurch die Optimierung kritischer Prozeßparameter zur Erzielung höchster Beschichtungsqualitäten.

## Patentansprüche

1. Verfahren zum Beschichten optischer Elemente, insbesondere optischer Elemente für mit Ultraviolettlicht arbeitende optische Systeme, in einer Arbeitskammer einer Beschichtungseinrichtung mit folgenden Schritten:
Bereitstellung mindestens einer Schleuseneinrichtung mit mindestens einer evakuierbaren, wahlweise von der Arbeitskammer abtrennbaren oder mit der Arbeitskammer verbindbaren Schleusenkammer;
Positionierung mindestens eines optischen Elementes in der Schleusenkammer;
Behandlung des optischen Elementes innerhalb der Schleusenkammer;
Angleichung der Atmosphären von Arbeitskammer und Schleusenkammer;
Überführung des optischen Elementes zwischen Schleusenkammer und Arbeitskammer unter Ausschluß der Umgebungsatmosphäre.

2. Verfahren nach Anspruch 1, **dadurch gekennzeichnet, daß** die Behandlung eine Reinigung des optischen Elementes in der Schleusenkammer umfasst, wobei die Reinigung vorzugsweise eine Bestrahlung des optischen Elementes mit Ultraviolettlicht (UV-Reinigung) umfasst, wobei insbesondere während der Reinigung, insbesondere während der UV-Reinigung, eine Evakuierung der Schleusenkammer durchgeführt wird.

3. Verfahren nach Anspruch 2, **dadurch gekennzeichnet, daß** vor und/oder während der UV-Reinigung die Atmosphäre in der Schleusenkammer mit einem Prozeßgas, insbesondere mit Sauerstoff angereichert wird.

4. Verfahren nach einem der vorhergehenden Ansprüche, **dadurch gekennzeichnet, daß** die Behandlung eine Vorreinigung mindestens einer Oberfläche eines zu beschichteten optischen Elementes zeitlich vor der Beschichtung umfasst, und/oder dass die Behandlung eine Nachreinigung von fertig beschichteten optischen Elementen in der Schleusenkammer umfasst.

5. Verfahren nach einem der vorhergehenden Ansprüche, **dadurch gekennzeichnet, daß** bei einer Mehrlagenbeschichtung mindestens ein Schritt der Behandlung, insbesondere eine Reinigung, zwischen zwei aufeinanderfolgenden Beschichtungsschritten durchgeführt wird.

6. Verfahren nach einem der vorhergehenden Ansprüche, **dadurch gekennzeichnet, daß** die Behandlung eine Messung mindestens einer optischen Eigenschaft eines optischen Elementes innerhalb der Schleusenkammer umfasst, insbesondere eine Messung von Transmissionsgrad, Reflexionsgrad, Absorptionsgrad o.dgl., wobei vorzugsweise die Messung innerhalb der Schleusenkammer in einer von der Umgebungsatmosphäre abweichenden Schleusenkammeratmosphäre durchgeführt wird, insbesondere in Vakuum.

7. Verfahren nach einem der vorhergehenden Ansprüche, **dadurch gekennzeichnet, daß** die Behandlung eine kontrollierte Temperaturführung des in der Schleusenkammer befindlichen optischen Elementes umfasst, insbesondere eine Temperaturänderung mit kontrollierter Temperaturänderungsrate und/oder ein Halten auf einer vorgebbaren Temperatur, wobei vorzugsweise zur Durchführung und/oder zur Unterstützung der kontrollierten Temperaturführung ein Gas in die Schleusenkammer eingeleitet wird, wobei das Gas vorzugsweise ein Heißgas mit einer oberhalb der Umgebungstemperatur liegenden Gastemperatur ist, und/oder wobei die kontrollierte Temperaturführung eine Einstrahlung von Wärmestrahlung auf das optische Element umfasst.

8. Verfahren nach einem der vorhergehenden Ansprüche, **dadurch gekennzeichnet, daß** während eines Arbeitsintervalls, in dem sich mindestens ein optisches Element in der abgeschlossenen Arbeitskammer befindet, in mindestens einer der Arbeitskammer zugeordneten Schleusenkammer eine Behandlung, insbesondere eine Reinigung, eine kontrollierte Temperaturführung und/oder eine Messung mindestens eines weiteren optischen Elementes durchgeführt wird.

9. Schleuseneinrichtung zum vakuumdichten Anschluß an eine mit mindestens einer Arbeitskammer (6) ausgestattete Beschichtungseinrichtung (2, 25) zum Beschichten optischer Elemente, insbesonderer optischer Elemente für mit Ultraviolettlicht arbeitende optische Systeme, die Schleuseneinrichtung (3, 26, 27) mit einem Gehäuse (11, 30), das mindestens eine evakuierbare Schleusenkammer (12, 33) umschließt, die mindestens eine Zugangsöffnung hat, welche mittels mindestens eines Schleusenorgans (13, 14, 35, 36) wahlweise zur Durchführung optischer Elemente öffenbar oder zum vakuumdichten Verschließen der Zugangsöffnung verschließbar ist, wobei der Schleusenkammer mindestens eine Behandlungseinrichtung (21, 22, 28, 31) zur Behandlung von in der Schleusenkammer angeordneten optischen Elementen zugeordnet ist.

10. Schleuseneinrichtung nach Anspruch 9, **dadurch gekennzeichnet, daß** mindestens eine Behandlungseinrichtung eine Reinigungseinrichtung zur vorzugsweise berührungslosen und/oder trockenen Reinigung mindestens einer Oberfläche des optischen Elementes (9) ist, wobei die Reinigungseinrichtung vorzugsweise mindestens eine Ultraviolettlichtquelle (21, 28) aufweist.

11. Schleuseneinrichtung nach Anspruch 9 oder 10, **dadurch gekennzeichnet, daß** das Gehäuse (11, 30) der Schleuseneinrichtung mindestens ein in eine Gehäusewand vakuumdicht eingelassenes Fenster (15) aufweist, das vorzugsweise aus einem für Ultraviolettlicht durchlässigen Material besteht, insbesondere aus Quarzglas, wobei vorzugsweise mindestens eine Ultraviolettlichtquelle (21) außerhalb der Schleusenkammer (12) derart im Bereich eines für Ultraviolettlicht transparenten Fensters (15) angeordnet ist, daß optische Elemente innerhalb der Schleusenkammer durch das Fenster hindurch mittels der UV-Lichtquelle (21) bestrahlbar sind.

12. Schleuseneinrichtung nach einem der Ansprüche 9 bis 11, **dadurch gekennzeichnet, daß** mindestens eine in die Schleusenkammer mündende Gasleitung (20) vorgesehen ist, die an eine externe Gasquelle (19) angeschlossen oder anschließbar ist, und/oder daß mindestens eine in die Schleusenkammer mündende Saugleitung (18) vorgesehen ist, die an eine Vakuumpumpe (17) angeschlossen oder anschließbar ist.

13. Schleuseneinrichtung nach einem der Ansprüche 9 bis 12, **dadurch gekennzeichnet, daß** ihr mindestens eine Meßeinrichtung (31) zur Messung mindestens einer Eigenschaft von in der Schleusenkammer (33) angeordneten optischen Elementen zugeordnet ist, wobei die Meßeinrichtung vorzugsweise zur Messung optischer Eigenschaften der Elemente ausgebildet ist.

14. Schleuseneinrichtung nach einem der Ansprüche 9 bis 13, **dadurch gekennzeichnet, daß** ihr mindestens eine Heizeinrichtung (22) zur Aufheizung von in der Schleusenkammer (12) angeordneten optischen Elementen zugeordnet ist, wobei die Heizeinrichtung vorzugsweise mindestens ein Strahlungsheizelement (22) aufweist.

15. Schleuseneinrichtung nach einem der Ansprüche 9 bis 14, **dadurch gekennzeichnet, daß** ihr mindestens eine Einrichtung zur Einleitung von Heißgas und/ oder mindestens eine Einrichtung zur Einleitung von temperiertem Prozeßgas in die Schleusenkammer zugeordnet ist.

16. Schleuseneinrichtung nach einem der Ansprüche 9 bis 15, **dadurch gekennzeichnet, daß** die Arbeitskammer (6) der Beschichtungseinrichtung frei von Einrichtungen zur Reinigung und/oder Heizung zu beschichtender optischer Elemente ist.

17. Beschichtungsanlage zum Beschichten optischer Elemente, insbesondere optischer Elemten für mit Ultraviolettlicht arbeitende optische Systeme, mit einer mindestens eine Arbeitskammer (6) aufweisenden Beschichtungseinrichtung (2), der mindestens eine Schleuseneinrichtung gemäß mindestens einem der Ansprüche 9 bis 16 zugeordnet ist.

18. Beschichtungsanlage nach Anspruch 17, **dadurch gekennzeichnet, daß** ihr mindestens zwei Schleuseneinrichtungen (26, 27) zugeordnet sind, wobei vorzugsweise eine Schleuseneinrichtung als Bestückungsschleuseneinrichtung (26) und eine andere Schleuseneinrichtung als Entnahmeschleuseneinrichtung (27) ausgebildet ist.

19. Beschichtungsanlage nach Anspruch 17 oder 18, **dadurch gekennzeichnet, daß** die Beschichtungseinrichtung und die Schleuseneinrichtung derart aneinander angepaßt sind, daß die Schleuseneinrichtung unter Bildung eines vakuumdichten Durchlasses zwischen Schleusenkammer und Arbeitskammer lösbar an der Beschichtungseinrichtung anbringbar ist.

20. Optisches Element, insbesondere Linse, Prisma, Spiegel, Filter o.dgl., mit mindestens einer Oberfläche, auf der eine Beschichtung angebracht ist, die gemäß dem Verfahren nach mindestens einem der Ansprüche 1 bis 8 hergestellt ist.
